Europäisches Patentamt

(19) European Patent Office

Office européen des brevets

(11) Numéro de publication: **0 237 116 B1**

(12) **FASCICULE DE BREVET EUROPEEN**

(45) Date de publication du fascicule du brevet: **13.06.90**

(51) Int. Cl.⁵: **G11C 7/00, G11C 7/06**

(21) Numéro de dépôt: **87200364.5**

(22) Date de dépôt: **02.03.87**

(54) **Memoire avec tampon amplificateur.**

(30) Priorité: **14.03.86 FR 8603681**

(43) Date de publication de la demande:
**16.09.87 Bulletin 87/38**

(45) Mention de la délivrance du brevet:
**13.06.90 Bulletin 90/24**

(84) Etats contractants désignés:
**DE FR GB IT NL**

(56) Documents cités:
**US-A- 4 003 034**
**US-A- 4 146 802**

**IBM TECHNICAL DISCLOSURE BULLETIN,**
**vol. 13, no. 9, février 1971, pages 2670-2671, New York,**
**US; J.G. SURGENT: "Insulated gate field-effect**
**transistor sense amplifier latch"**

(73) Titulaire: **RTC-COMPELEC, 130, Avenue Ledru-Rollin,**
**F-75011 Paris(FR)**

(84) Etats contractants désignés: **FR**

(73) Titulaire: **N.V. Philips' Gloeilampenfabrieken,**
**Groenewoudseweg 1, NL-5621 BA Eindhoven(NL)**

(84) Etats contractants désignés: **DE GB IT NL**

(72) Inventeur: **Lanfranca, Michel, Societe Civile**
**S.P.I.D 209, rue de l'Université, F-75007 Paris(FR)**

(74) Mandataire: **Hoarau de La Source, Jean Marie Pierre,**
**S.P.I.D. 209, rue de l'Université, F-75007 Paris(FR)**

**Description**

La présente invention a pour objet une mémoire comportant un ensemble de cellules de mémoire pour mémoriser chacune un bit à lire avec des moyens de lecture agissant sous la commande d'un signal de commande de lecture, un ensemble de lignes de bit chacune étant munie de moyens de précharge pour être préchargée sous la commande d'un signal de commande de précharge, et, situé en bout de chaque ligne de bit, un tampon amplificateur de lecture agissant sous la commande d'un transistor de transmission pour délivrer sur une ligne de sortie un signal stable amplifié représentatif de la valeur d'un bit lu.

Ce genre de mémoire est bien connu et souvent utilisé dans l'industrie de l'électronique et de l'informatique.

Un exemple connu d'une telle mémoire est décrit dans la publication "IEEE International Solid-State Circuits Conference, 12 Février 1982, IEEE, New York (US) S.Konishi - A 64 Kb CMOS - RAM p. 258-259".

Pratiquement toutes les mémoires, vive, morte etc..., sont organisées sous forme d'une matrice de cellules de bit, chaque cellule étant située au croisement d'une colonne et d'une rangée; lors d'une opération de lecture une seule cellule de chaque rangée est lue et l'information est transmise sur une ligne de bit laquelle est commune à toutes les cellules de la même rangée; le dispositif de lecture proprement dit, ici appelé tampon amplificateur de lecture, est situé en bout de chaque ligne de bit; la présente invention concerne plus particulièrement le tampon amplificateur de lecture.

Dans les mémoires connues, réalisées notamment en technologie MOS, le tampon amplificateur comporte généralement un amplificateur ("sense amplifier"), un transistor de transmission ("passing") commandé par la commande de lecture, et un tampon ("latch"); il est donc composé d'au moins huit transistors; la présente invention a pour but de réduire ce nombre de transistors.

Une mémoire, selon la présente invention, est particulièrement remarquable en ce que le tampon amplificateur de lecture comporte premièrement, le dit transistor de transmission dont une première électrode est connectée à la dite ligne de bit, deuxièmement, un premier inverseur connecté entre la deuxième électrode du transistor de transmission et la dite ligne de sortie, troisièmement, un deuxième inverseur connecté en tête-bêche sur le dit premier inverseur, et en ce que d'une part la grille du dit transistor de transmission est connectée non seulement à la dite commande de lecture mais aussi à la dite commande de précharge pour que le dit transistor de transmission soit passant non seulement pendant la lecture, mais aussi pendant la précharge, d'autre part le dit deuxième inverseur est faible par rapport au dit premier inverseur.

Ainsi le tampon amplificateur ne comporte que cinq transistors ce qui est un avantage puisque l'on recherche actuellement la plus haute intégration dans le domaine des circuits intégrés et que cette économie en nombre de transistors se répète sur chaque ligne de bit de la mémoire; dans certains types de mémoires il y a jusqu'à 4 lignes de bit par rangée; ainsi l'économie de place, qui se mesure en mm$^2$ de substrat, est donc considérable.

Dans un mode de réalisation avantageux, sachant que chaque ligne de bit a une capacité équivalente relativement importante, l'invention est remarquable en ce qu'une capacité parasitaire, présente à l'entrée du tampon amplificateur, est relativement faible par rapport à la dite capacité équivalente de la ligne de bit.

Ainsi, lors d'une lecture, le temps de décharge sera d'autant plus court que la capacité sera faible; cette caractéristique vise à diminuer le temps global de lecture.

L'invention sera bien comprise au vu de la description d'un exemple, non limitatif, de réalisation s'appuyant sur les dessins suivants :

Figure 1. Une ligne de bit de mémoire RAM connue.

Figure 2. Une ligne de bit de mémoire RAM selon l'invention.

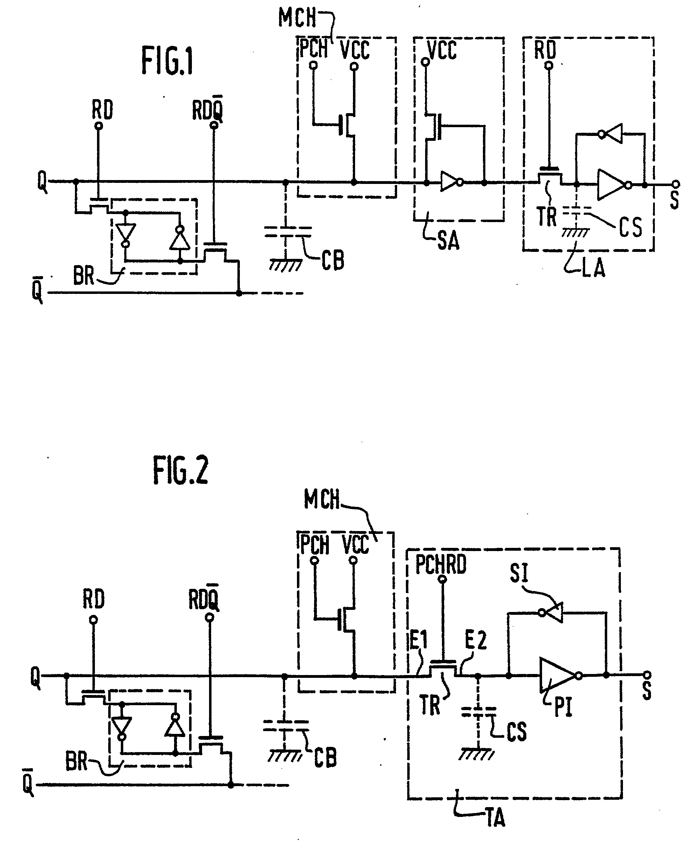

Sur la figure 1 est représentée une cellule de mémoire connue BR accessible par deux transistors, l'un commandé par la commande de lecture RD pour transférer l'information lue sur la ligne de bit Q, l'autre commandé par la commande de lecture RD $\overline{Q}$ pour transférer l'information lue sur la ligne de bit complémentaire $\overline{Q}$; les autres cellules de mémoire de la même rangée, ici non représentées, sont similairement connectées aux deux lignes de bit Q et $\overline{Q}$; sur certaines mémoires il y a jusqu'à quatre lignes de bit par rangée ainsi que décrit dans le brevet US 4 395 765; le nombre de rangées est évidemment dépendant de la taille de la mémoire; sur la figure une seule ligne de bit est représentée en détail, les autres lui sont similaires.

La ligne de bit Q est munie de moyens de précharge MCH connus pour précharger la ligne de bit sous la commande d'un signal de commande de précharge PCH; la capacité équivalente CB de la ligne de bit est, pour mémoire, ici symboliquement représentée, c'est une capacité qui résulte principalement de la longueur de la ligne de bit; le circuit SA est un amplificateur-sélecteur ("Sense Amplifier") et le circuit LA est un tampon ("Latch") dont le transistor de transmission TR ("passing") agit sous la commande du signal de commande de lecture RD, CS étant une capacité parasitaire à l'entrée du tampon; sachant que chaque inverseur est composé de deux transistors, il est clair que les deux circuits (SA+LA), qui constituent un tampon amplificateur de lecture situé en bout de ligne de bit, comportent huit transistors; le signal de sortie, stable et amplifié, est disponible après lecture sur la ligne de sortie S.

Sur la figure 2, un tampon amplificateur TA conforme à l'invention est représenté situé en bout de ligne de bit Q; les autres éléments, qui sont inchangés par rapport à la figure 1, sont représentés identiquement et avec les mêmes repères.

Le transistor de transmission TR dont une première électrode E1 est connectée à la ligne de bit est maintenant commandé sur sa grille par la commande PCHRD laquelle est active non seulement pendant la dite commande de lecture RD mais aussi pendant la commande de précharge PCH; un premier inverseur PI est connecté entre la deuxième électrode E2 et la ligne de sortie S; un deuxième inverseur SI est connecté en tête-bêche sur le premier inverseur PI; la capacité CS est une capacité parasitaire représentant le capacité à l'entrée du tampon SI/PI; le deuxième inverseur est faible par rapport au premier inverseur.

Le fonctionnement du circuit est le suivant: pendant la précharge, commande PCH active, la ligne de bit Q est préchargée ainsi que la capacité parasitaire CS puisque le transistor de transmission TR est passant; le signal haut ainsi présent sur l'électrode E2 est inversé par l'inverseur PI et la ligne de sortie S porte un signal bas; pendant la lecture deux cas peuvent se présenter selon le contenu de la cellule de mémoire : a) si la ligne de bit Q conserve la valeur 1, les valeurs établies pendant la précharge restent inchangées et la ligne de sortie conserve son niveau bas; b) si la ligne de bit Q est tirée à zéro, les deux capacités CB et CS se déchargent progressivement jusqu'à ce que l'inverseur PI bascule pour, dans ce cas, délivrer sur la ligne de sortie un niveau haut. Pour que l'inverseur PI puisse basculer, il est clair que l'inverseur SI doit être faible pour ne pas contrarier la décharge des capacités pendant la lecture; par contre, après la lecture, lorsque le transistor de transmission TR n'est pas passant, l'inverseur SI doit être suffisant pour compenser tout changement d'état intempestif, notamment la décharge, de la capacité parasitaire; la décharge serait sinon inévitable à la longue du fait des courants de fuite. Pour que la vitesse de lecture soit assez rapide, il est clair que la capacité parasitaire CS doit être relativement faible par rapport à la capacité équivalente CB de la ligne de bit. Le tampon amplificateur ainsi réalisé ne comporte que cinq transistors; de plus les deux transistors de l'inverseur SI sont des petits transistors; il en résulte un gain de surface de substrat considérable.

Pour fixer les idées, dans un exemple de réalisation selon l'invention, la capacité équivalente CB a sensiblement la valeur de $10^{-12}$ farad, alors que la capacité parasitaire CS a une valeur de l'ordre de $10^{-13}$ à $5.10^{-14}$ farad, par ailleurs l'inverseur PI a une puissance de 20 à 40 fois supérieure à celle de l'inverseur SI; ces valeurs indicatives ne sont, bien sûr, pas limitatives.

La présente invention concerne tous les types de mémoire : vive, morte, ou autre; les caractéristiques électriques des divers éléments du tampon amplificateur sont notamment fonction de la taille de la mémoire, et aussi de la puissance demandée sur la ligne de sortie S.

On notera que le signal de sortie est toujours remis à zéro pendant la phase de précharge, ce signal n'est donc pas valide pendant cette phase de précharge; ceci n'est pas un inconvénient car, dans la plupart des cas, les dispositifs connectés à la sortie de la mémoire ne sont activés qu'à la fin de la lecture.

## Revendications

1. Mémoire comportant un ensemble de cellules de mémoire (BR) pour mémoriser chacune un bit à lire avec des moyens de lecture agissant sous la commande d'un signal de commande de lecture (RD), un ensemble de lignes de bit (Q) chacune étant munie de moyens de précharge (MCH) pour être préchargée sous la commande d'un signal de commande de précharge (PCH), et, situé en bout de chaque ligne de bit, un tampon amplificateur de lecture agissant sous la commande d'un transistor de transmission (TR) pour délivrer sur une ligne de sortie (S) un signal stable amplifié représentatif de la valeur d'un bit lu, caractérisée en ce que le tampon amplificateur de lecture (TA) comporte premièrement, le dit transistor de transmission (TR) dont une première électrode (E1) est connectée à la dite ligne de bit (Q), deuxièmement, un premier inverseur (PI) connecté entre la deuxième électrode (E2) du transistor de transmission et la dite ligne de sortie (S) , troisièmement, un deuxième inverseur (SI) connecté en tête-bêche sur le dit premier inverseur (PI), et en ce que d'une part la grille du dit transistor de transmission (TR) est connectée non seulement à la dite commande de lecture (RD) mais aussi à la dite commande de précharge (PCH) pour que le dit transistor de transmission (TR) soit passant non seulement pendant la lecture, mais aussi pendant la précharge, d'autre part le dit deuxième inverseur (SI) est faible par rapport au dit premier inverseur (PI).

2. Mémoire selon la revendication 1, chaque ligne de bit (Q) ayant une capacité (CB) équivalente, caractérisée en ce qu'une capacité parasitaire (CS), présente à l'entrée du tampon amplificateur (TA), est relativement faible par rapport à la dite capacité (CB) équivalente de la ligne de bit (Q).

## Claims

1. A memory comprising an array of memory cells (BR), each for storing a bit to be read, with read means which are responsive to a read control signal (RD), an array of bit lines (Q), each provided with precharging means (MCH) for being precharged in response to a precharge control signal (PCH), and, located at the end of each bit line, a read buffer amplifier controllable by a transmission transistor (TR) for producing on an output line (S) an amplified stable signal which is representative of the value of a bit read, characterized in that the read buffer amplifier (TA) comprises firstly said transmission transistor (TR), a first electrode (E1) of which is connected to said bit line (Q), secondly a first inverter (PI) connected between the second electrode (E2) of the transmission transistor and said output line (S), and thirdly a second inverter (SI) connected in a head-to-tail configuration to said first inverter (PI), and in that on the one hand the control electrode of said transmission transistor (TR) is connected not only to said read control (RD) but also to said precharging control (PCH) so as to ensure that said transmission transistor (TR) will be conductive not only during reading but also during the precharging, and on the other hand this second inverter (SI) is weak compared with the first inverter (PI).

2. A memory as claimed in claim 1, each bit line (Q) having an equivalent capacitance (CB) characterized in that a parasitic capacitance (CS) present at the input of the buffer amplifier (TA) is relatively small compared with said equivalent capacitance (CB) of the bit line (Q).

## Patentansprüche

1. Speicher mit einer Anzahl von Speicherelementen (BR) je zum Speichern eines Bits, das mit Lesemitteln unter der Steuerung eines Lesesteuersignals (RD) gelesen wird, mit einer Anzahl von Bitleitungen (Q) je mit Vorlademitteln (MCH) zum Voraufladen dieser Leitungen unter der Steuerung eines Aufladesteuersignals (PCH) und mit, am Ende jeder Bitleitung, einem Lese-Pufferverstärker gesteuert von einem Übertragungstransistor (TR) zur Belieferung einer Ausgangsleitung (S) mit einem den Wert eines gelesenen Bits darstellenden stabilen verstärkten Signals, dadurch gekennzeichnet, daß der Lese-Pufferverstärker (TA) erstens den betreffenden Übertragungstransistor (TR), von dem eine erste Elektrode (E1) mit der Bitleitung (Q) verbunden ist, zweitens eine erste Umkehrstufe (PI), der zwischen der zweiten Elektrode (E2) des Übertragungstransistors und der Ausgangsleitung (S) angeschlossen ist, und drittens eine zweite Umkehrstufe (SI) enthält, die in Kopf-Schwanz-Verbindung mit der ersten Umkehrstufe (PI) verbunden ist, und daß einerseits das Gitter dieses Übertragungstransistors (TR) nicht nur vom Lesesteuersignal (RD), sondern auch vom Aufladesteuersignal (PCH) gesteuert wird, damit dieser Übertragungstransistor (TR) nicht nur während des Lesevorgangs, sondern auch beim Voraufladen leitend ist, und andererseits die zweite Umkehrstufe (SI) in bezug auf die erste Umkehrstufe (PI) schwach ist.

2. Speicher nach Anspruch 1, wobei jede Bitleitung (Q) eine äquivalente Kapazität (CB) besitzt, dadurch gekennzeichnet, daß eine am Eingang des Pufferverstärkers (TA) vorhandene Streukapazität in bezug auf die äquivalente Kapazität der Bitleitung (Q) verhältnismäßig schwach ist.

FIG.1

FIG.2